# EUROPEAN PATENT APPLICATION

(11) **EP 4 734 678 A1**
(43) Date of publication of application: **29.04.2026**
(21) Application number: 25188713.9
(22) Date of filing: 10.07.2025
(51) Int. Cl.: H05K 5/02, H05K 7/14, H05K 7/20, H05K 5/30, H02M 7/00

(54) **INVERTER FOR ENERGY STORAGE SYSTEM AND METHOD OF INSTALLING THE INVERTER FOR ENERGY STORAGE SYSTEM**

(30) Priority: 28.10.2024 KR 20240148985
(71) Applicant: Hanwha Solutions Corporation, Jung-gu Seoul 04541 (KR)
(72) Inventor: KIM, Hak Sun, 04541 Seoul (KR); CHOI, You Chang, 04541 Seoul (KR); JEON, Dong Jun, 04541 Seoul (KR); PARK, Je Hyun, 04541 Seoul (KR)
(74) Representative: Mooser, Sebastian Thomas

(57) **Abstract**

An inverter for an energy storage system includes a main case having an internal space and installed in an external structure, a circuit board disposed in the internal space and configured to interconvert direct current power and alternating current power into each other, a heat dissipation case disposed to cover the main case and protruding along a first direction, and a hood cover surrounding the heat dissipation case and connected to the main case.

## Description

### BACKGROUND

### 1. Field

The disclosure relates to an inverter for an energy storage system (ESS) and a method of installing the inverter for an ESS.

### 2. Description of the Related Art

In general, an inverter for an energy storage system (ESS) is a device which converts direct current (DC) electricity generated by an electric energy generation device, such as a solar module, into alternating current (AC) electricity and stores the electric energy in a battery, which is an ESS, and is a device which supplies AC electricity to a power grid and home appliances using AC electricity and maintains power quality by controlling an output voltage and a frequency.

An inverter for an ESS may be connected to a solar panel and a power grid and used independently, and may also be integrated with other external devices, such as an ESS, and utilized as an all-in-one solution. Such a configuration may improve the efficiency of power conversion and storage.

Because an existing inverter for an integrated ESS is formed integrally with an external device, there is a problem in that the entire product has to be replaced even when defects occur in only some components. Furthermore, there is a problem in that a cost is incurred in a process of transporting and reinstalling an entire product.

### SUMMARY

The disclosure provides an inverter for an energy storage system (ESS) with improved convenience of installation and replacement and a method of installing the inverter for an ESS.

The technical objectives to be achieved by the disclosure are not limited to the technical objectives described above, and other technical objectives that are not described herein will be clearly understood from the following description by those of ordinary skill in the art.

According to an embodiment, an inverter for an ESS includes a main case having an internal space and installed in an external structure, a circuit board disposed in the internal space and configured to interconvert direct current (DC) power and alternating current (AC) power into each other, a heat dissipation case disposed to cover the main case and protruding along a first direction, and a hood cover surrounding the heat dissipation case and connected to the main case.

In an embodiment, the main case may include a main body having the internal space in which the circuit board is accommodated and having an opening on another side of the main body, and a door coupled to the main body and capable of covering the opening.

In an embodiment, the main body may have a guide protrusion protruding from a surface of the main body.

In an embodiment, the door may include an extension tab connected to the external structure and having fixing holes spaced apart from each other by preset intervals.

In an embodiment, the main case may further include a safety rod having an end rotatably connected to the main body and another end supported on the door.

In an embodiment, the safety rod may have a rod hole having an elongated hole shape into which a rotary pin of the main body is inserted.

In an embodiment, the heat dissipation case may include a heat dissipation fin protruding along the first direction.

In an embodiment, the hood cover may include a pair of side covers extending along a side surface of the heat dissipation case and a connection cover connecting the pair of side covers to each other.

In an embodiment, the hood cover may have a plurality of cover holes communicating an interior with an exterior and extending along the first direction.

In an embodiment, the inverter may further include a fastening member having a first fastening terminal connected to the external structure and a second fastening terminal connected to the hood cover.

In an embodiment, the inverter may further include a support member disposed between the heat dissipation case and the external structure and supporting the heat dissipation case.

According to another embodiment, a method of installing an inverter for an ESS includes seating, on an external structure, a main case accommodating a circuit board therein and a heat dissipation case disposed on a side of the main case, aligning positions of the main case and the heat dissipation case with a position of the external structure, fastening the main case to the external structure, and installing a hood cover to cover the heat dissipation case.

In an embodiment, the aligning may include matching a center of the main case with a center of the external structure, and fixing the main case to the external structure in a state in which the center of the main case matches the center of the external structure.

In an embodiment, the installing of the hood cover may include disposing the hood cover to surround the heat dissipation case, and fixing the hood cover to the external structure by fastening a first fastening terminal of a fastening member to the external structure and fastening a second fastening terminal of the fastening member to the hood cover.

Other aspects, features, and advantages of the disclosure will become better understood through the accompanying drawings, the appended claims, and the detailed description.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a block diagram schematically illustrating a power generation system including an inverter for an energy storage system (ESS), according to an embodiment;
FIG. 2 is a diagram illustrating a state in which an inverter for an ESS is coupled to an external structure, according to an embodiment;
FIG. 3 is an exploded perspective view of the inverter for an ESS illustrated in FIG. 2;
FIG. 4 is a perspective view of the inverter for an ESS illustrated in FIG. 2;
FIG. 5 is a diagram illustrating a state in which a door of the inverter for an ESS illustrated in FIG. 2 is opened;
FIG. 6 is an enlarged view of region A of FIG. 5;
FIG. 7 is a rear view of the inverter for an ESS illustrated in FIG. 2;
FIG. 8 is a bottom view of the inverter for an ESS illustrated in FIG. 2;
FIG. 9 is a diagram illustrating a state in which a heat dissipation case is seated on a support member, according to an embodiment;
FIG. 10 is a diagram illustrating a state in which a fixing member aligns a main case and an external structure, according to an embodiment;
FIG. 11 is a diagram illustrating a state in which a main case is fastened to an external structure, according to an embodiment;
FIG. 12 is a diagram illustrating a state in which a hood cover is coupled to an external structure, according to an embodiment; and
FIG. 13 is a flowchart schematically showing a method of installing an inverter for an ESS, according to an embodiment.

### DETAILED DESCRIPTION

As the present description allows for various changes and numerous embodiments, certain embodiments will be illustrated in the drawings and described in detail in the written description. Effects and features of the disclosure, and methods of achieving them will be clarified with reference to embodiments described below in detail with reference to the drawings. However, the disclosure is not limited to the following embodiments and may be embodied in various forms.

Hereinafter, embodiments will be described in detail with reference to the accompanying drawings. When describing embodiments with reference to the accompanying drawings, the same or corresponding elements are denoted by the same reference numerals, and redundant descriptions thereof are omitted.

In the following embodiments, the terms "first," "second," etc. are not used in a restrictive sense and are used to distinguish one element from another.

The singular forms as used herein are intended to include the plural forms as well unless the context clearly indicates otherwise.

It will be further understood that the terms "include" and/or "comprise" used herein specify the presence of stated features or elements, but do not preclude the presence or addition of one or more other features or elements.

In the following embodiments, it will be understood that, when a region or element is referred to as being in front of, at the rear of, on, or below another region or element, this may include not only a case where the region or element is in direct contact with the other region or element, but also a case where intervening regions or elements may be present therebetween.

Also, sizes of elements in the drawings may be exaggerated or reduced for convenience of explanation. For example, because sizes and thicknesses of elements in the drawings are arbitrarily illustrated for convenience of explanation, the disclosure is not necessarily limited thereto.

In addition, it is noted that, in the drawings, some elements may be omitted, only a portion of an element may be illustrated, or an element may be schematically illustrated, when it is determined that elements are sufficient or necessary in describing a region or element, or for the purpose of simplifying the drawings.

It will be further understood that, when regions or elements are referred to as being connected to each other, the regions or elements may be directly connected to each other or indirectly connected to each other with intervening regions or elements therebetween.

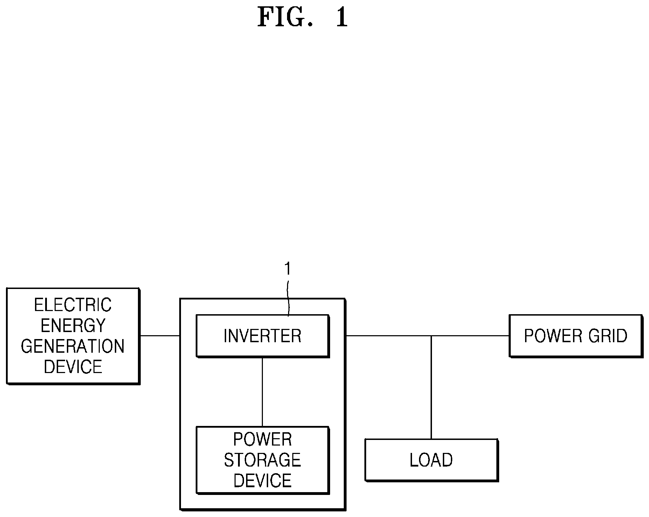

FIG. 1 is a block diagram schematically illustrating a power generation system including an inverter 1 for an energy storage system (ESS), according to an embodiment.

Referring to FIG. 1, the inverter 1 for an ESS converts direct current (DC) electricity generated by an electric energy generation device, such as a solar module, into alternating current (AC) electricity and supplies the AC electricity to a load and a power grid or stores the AC electricity in a power storage device. The inverter 1 for an ESS may include a circuit board capable of interconverting the DC electricity and the AC electricity into each other.

The load is a general term for all devices which consume electricity and may include household electrical appliances, heating and cooling systems, lighting in commercial facilities, machinery in equipment industries, or the like. Because the load generally uses AC electricity, DC electricity supplied for charging an energy storage device may be converted into AC electricity through the inverter and then supplied to the load.

The power grid, which is a network to which AC electricity converted through the inverter is supplied, may be connected to power distribution networks of houses or buildings so that the supplied electricity may be distributed thereto.

The power storage device, also referred to as an ESS, is a device which stores electricity generated by the electric energy generation device, such as a solar module. Accordingly, surplus power generated by the electric energy generation device may be stored in the power storage device and supplied externally when power is needed.

Referring to FIG. 1, the inverter 1 for an ESS may be formed by being connected to or integrated with the power storage device. Accordingly, DC electricity generated by the electric energy generation device may be stored in the power storage device, converted into AC electricity by the inverter 1 for an ESS, and then supplied to the load, the power grid, etc.

However, the disclosure is not limited thereto, and the inverter 1 for an ESS may be connected to or integrated with various components which constitute the power generation system, such as a converter, a battery management system (BMS), or a power management system, within the technical concept of converting external DC electricity into AC electricity.

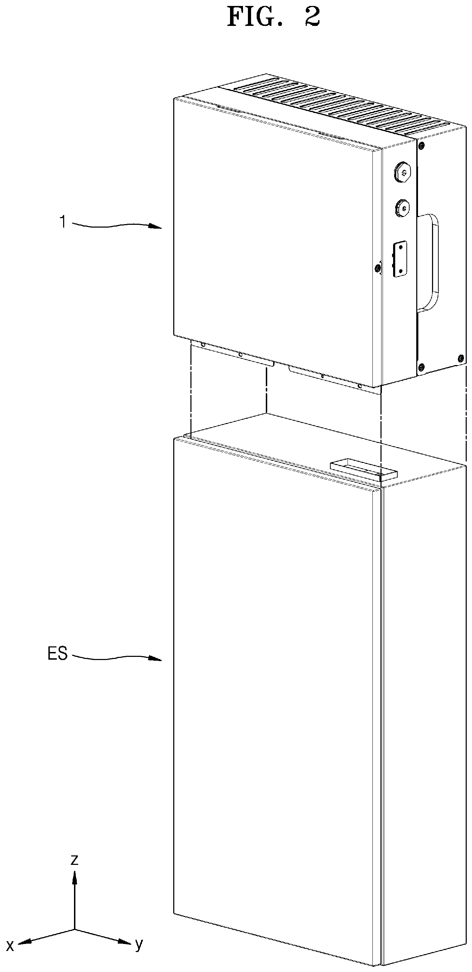

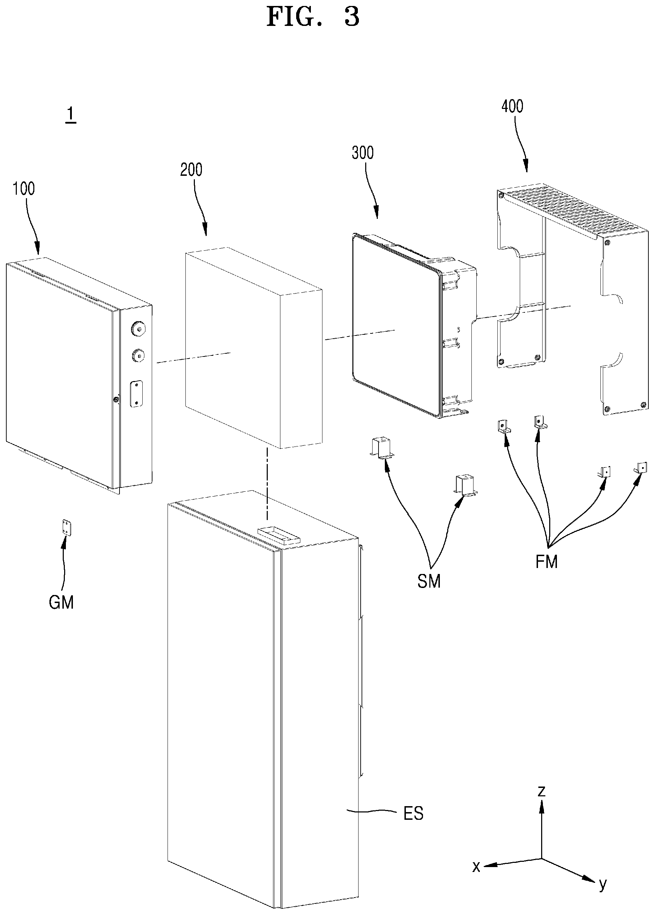

FIG. 2 is a diagram illustrating a state in which an inverter 1 for an ESS is coupled to an external structure, according to an embodiment. FIG. 3 is an exploded perspective view of the inverter 1 for an ESS illustrated in FIG. 2.

Referring to FIG. 2, the inverter 1 for an ESS, which converts DC electricity into AC electricity, may be installed in various external structures ES. The inverter 1 for an ESS may be installed by being seated on a surface of the external structure ES and then fastened thereto.

In the present specification, the term "fastening" refers to a process of connecting or fixing two or more parts in a machine or a structure. The term "fastening element" refers to a connection device, such as a screw, a bolt, a nut, or a rivet, which is used to connect and fix two parts in a fastening process.

In the present specification, the external structure ES may include various devices which are connectable to the inverter 1 for an ESS. For example, the external structure ES may include a converter, a BMS, a power management system, and a battery, which are listed above.

The inverter 1 for an ESS and the external structure ES may be electrically connected to each other through a DC connector (not shown) or an AC connector (not shown). Due to this, the inverter 1 for an ESS may receive DC electricity or may convert the received DC electricity into AC electricity and transmit the AC electricity to the outside.

Accordingly, a terminal groove having a hole through which a connector, a terminal, etc. passes may be formed on a surface of the inverter 1 for an ESS, and a terminal groove may also be formed on a surface of the external structure ES to face the terminal groove formed on the inverter 1 for an ESS.

In case that the inverter 1 for an ESS is installed in the external structure ES, the respective terminal grooves may be disposed to face each other. At this time, the connector and the terminal, which are connected to the inverter 1 for an ESS, may pass between the terminal grooves facing each other and be coupled to the external structure ES, and may electrically connect the two components or transmit electrical signals.

Referring to FIG. 3, the inverter 1 for an ESS may include a main case 100, a circuit board 200, a heat dissipation case 300, and a fastening member FM.

The main case 100, the circuit board 200, and the heat dissipation case 300 may be coupled to each other on the external structure ES along a first direction. The circuit board 200 may be disposed in an internal space of the main case 100. The heat dissipation case 300 may be disposed to cover the main case 100.

The main case 100 and the heat dissipation case 300 may be manufactured as independent components and then coupled to each other. However, the disclosure is not limited thereto, and the main case 100 and the heat dissipation case 300 may be integrally formed as a whole.

In the present specification, the first direction may refer to an x-axis direction. For example, the first direction may refer to a -x-axis direction in FIG. 1 and may refer to a direction in which the heat dissipation case 300 protrudes. Furthermore, in the present specification, a second direction may refer to a y-axis direction and a third direction may refer to a z-axis direction.

Referring again to FIG. 2, the inverter 1 for an ESS may be coupled to the external structure ES along the third direction. However, the disclosure is not limited thereto, and the inverter 1 for an ESS may be coupled in various directions according to the shape of the external structure ES and the disposition of internal components.

The circuit board 200 may be disposed in the internal space of the main case 100 and may interconvert DC power and AC power into each other. The circuit board 200 may include power semiconductors, such as metal-oxide semiconductor field effect transistors (MOSFETs) and insulated gate bipolar transistors (IGBTs), control circuits, filters, sensors, or printed circuit boards (PCBs).

The connectors may be electrically connected to the respective components of the circuit board 200 and may convert power, transmit the converted AC electricity to an external device, and control the operation of the inverter 1 for an ESS.

The heat dissipation case 300 may protrude along the first direction. As the heat dissipation case 300 protrudes, the opposite side of the protruding portion may be concavely formed to provide an internal space. A portion of the circuit board 200 may be accommodated in the internal space of the heat dissipation case 300. Accordingly, the circuit board 200 may be completely surrounded by the main case 100 and the heat dissipation case 300.

The heat dissipation case 300 may externally release heat generated in the internal spaces of the main case 100 and the heat dissipation case 300.

Because the heat dissipation case 300 externally releases heat generated in the process of converting power in the circuit board 200, the heat dissipation case 300 may prevent a deterioration in the performance of the electrical components or an occurrence of defects due to excessive accumulation of heat in the inverter 1 for an ESS.

This may extend the life of the internal components and improve the stability and reliability of the inverter 1 for an ESS.

A hood cover 400 may surround the heat dissipation case 300 and may be connected to the main case 100. The hood cover 400 may be disposed to cover a side surface and an upper surface of the heat dissipation case 300 and may protect the heat dissipation case 300 from the outside.

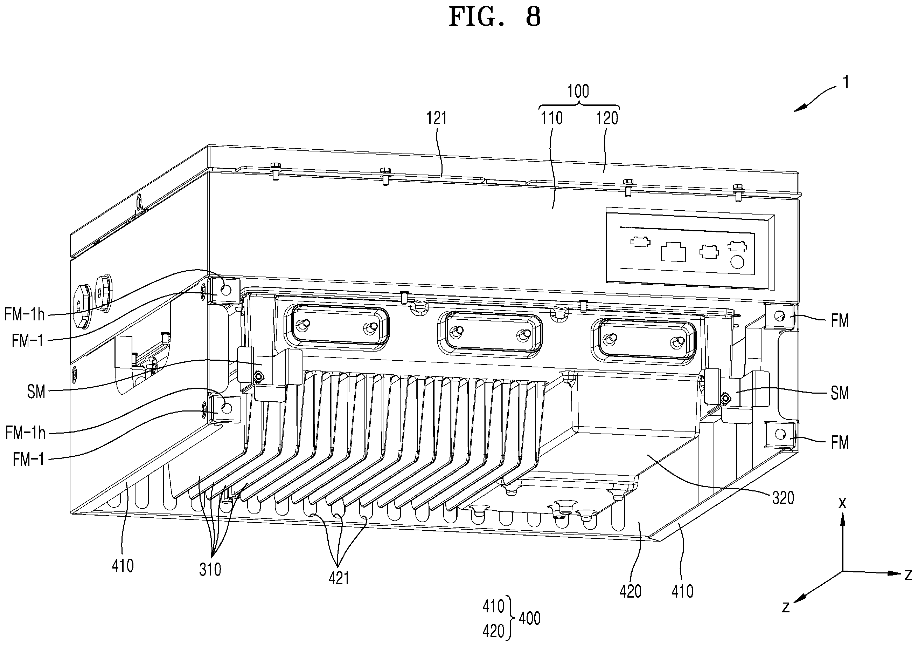

The hood cover 400 may have a plurality of cover holes (see 421 of FIG. 8) extending along the first direction in a surface of the hood cover 400. The plurality of cover holes (see 421 of FIG. 8) may enable heat from the heat dissipation case 300 to be effectively released along the third direction.

A lower end portion of the hood cover 400 may be connected to an upper surface of the external structure ES. For example, a portion corresponding to an edge of a lower end of the hood cover 400 may be fastened to the external structure ES by the fastening member FM. Due to this, the inverter 1 for an ESS may be stably fixed on the external structure ES.

The fastening member FM may have an end connected to the external structure ES and another end connected to the hood cover 400. The fastening member FM may connect the external structure ES and the hood cover 400 to each other and fix the external structure ES and the hood cover 400 to each other in a connected state.

A plurality of fastening members FM may be provided. The plurality of fastening members FM may be respectively disposed on opposite sides (opposite sides in the second direction) of the lower end portion of the hood cover 400 and may fix the opposite sides of the hood cover 400 to the external structure ES.

In some embodiments, the fastening members FM may be spaced apart from each other along the edge of the lower end portion of the hood cover 400 in the first direction and may fix the hood cover 400 to the external structure ES.

Referring to FIG. 3, the inverter 1 for an ESS may further include a fixing member GM and a support member SM.

The fixing member GM may have a side connected to the main case 100 and another side connected to the external structure ES. In case that the main case 100 is installed in the external structure ES, the fixing member GM may guide the two components to be aligned with the same center.

The support member SM may be disposed between the heat dissipation case 300 and the external structure ES. A surface of the support member SM may come into contact with the external structure ES, and another surface of the support member SM facing the surface of the support member SM may come into contact with the heat dissipation case 300.

Due to this, the support member SM may stably support the heat dissipation case 300 having a protruding shape, and the heat dissipation case 300 and the external structure ES may be spaced apart from each other by preset intervals.

A plurality of support members SM may be provided. The plurality of support members SM may be respectively disposed on opposite sides of the heat dissipation case 300.

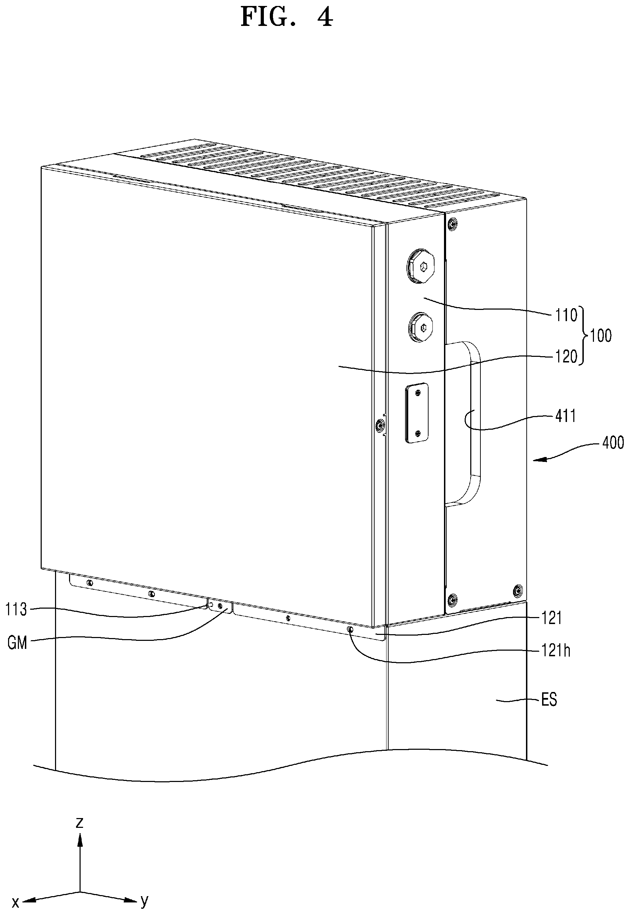

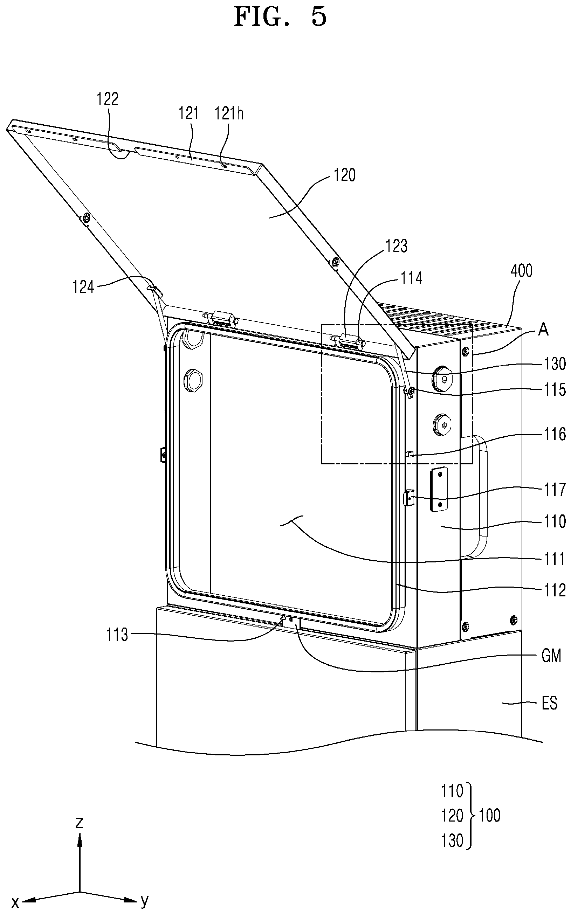

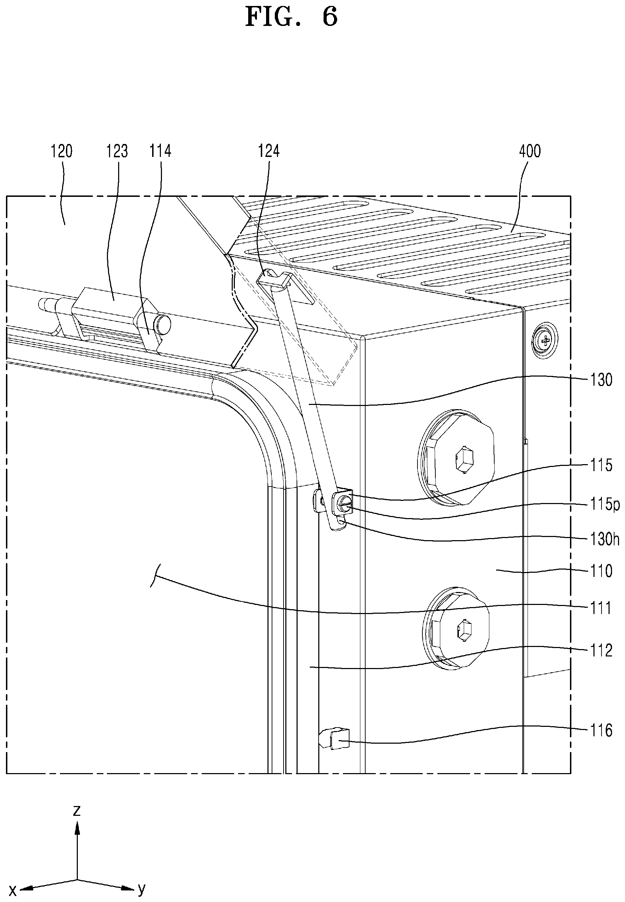

FIG. 4 is a perspective view of the inverter for an ESS illustrated in FIG. 2. FIG. 5 is a diagram illustrating a state in which a door of the inverter for an ESS illustrated in FIG. 2 is opened. FIG. 6 is an enlarged view of region A of FIG. 5.

Referring to FIGS. 4 and 5, the main case 100 may include a main body 110, a door 120, and a safety rod 130.

The main case 100 may have an internal space and may be installed in the external structure ES. The circuit board 200 may be disposed in the internal space of the main case 100.

The main body 110 may accommodate the circuit board 200 in the internal space and may have an opening 111 in another surface of the main body 110. The opening 111 of the main body 110 may be covered by the door 120 to be described below.

The main body 110 may include the opening 111, a shielding portion 112, a guide protrusion 113, a hinge bracket 114, a rod bracket 115, a fixing clip 116, and a door bracket 117. All the components may be disposed on a surface of the main body 110 in which the opening 111 is formed.

The shielding portion 112 may be disposed along the circumference of the opening 111 and may block electromagnetic waves generated in a process of converting power in the circuit board 200, thereby preventing the electromagnetic waves from affecting surrounding equipment.

The shielding portion 112 may be formed of various materials. For example, the shielding portion 112 may be formed of aluminum, steel, polycarbonate, acrylonitrile butadiene styrene (ABS), silicone, rubber, or the like and may be disposed along the circumference of the opening 111. The shielding portion 112 may be variously modified by using various materials within the technical concept of blocking electromagnetic waves emitted from the circuit board 200.

The guide protrusion 113 may protrude from a surface of the main body 110. For example, the guide protrusion 113 may be formed on a lower side of the main body 110 adjacent to the external structure ES and may protrude in a direction opposite to the first direction, that is, in a direction opposite to the protruding direction of the heat dissipation case 300.

The guide protrusion 113 may be coupled to the fixing member GM to be described below. A side of the fixing member GM may be coupled to the main body 110 and another side of the fixing member GM may be coupled to the external structure ES, so that the center of the main body 110 may match the center of the external structure ES.

Accordingly, a protrusion, which is connectable to the fixing member GM, may also protrude from the surface of the external structure ES, and the fixing member GM may be coupled to the guide protrusion 113 and the protrusion of the external structure ES and may align the external structure ES with the inverter 1 for an ESS when installing the inverter 1 for an ESS.

In some embodiments, a plurality of guide protrusions 113 may be formed on the surface of the main body 110. The plurality of guide protrusions 113 may be disposed in a row along the third direction. Accordingly, the inverter 1 for an ESS and the external structure ES may be aligned more precisely.

Referring to FIG. 6, the hinge bracket 114 may be connected to the door 120 and may be disposed at an upper end portion of the main body 110. A plurality of hinge brackets 114 may be provided. For example, the plurality of hinge brackets 114 may be respectively disposed on opposite sides of the main body 110.

The hinge bracket 114 may be hinged to the door 120 to be described below. Accordingly, the door 120 may be rotatably connected to the main body 110.

The rod bracket 115 is a portion where an end of the elongated safety rod 130 is accommodated. A plurality of rod brackets 115 may be provided. The plurality of rod brackets 115 may be respectively disposed on opposite sides of the main body 110. The rod bracket 115 may be provided in a shape that surrounds opposite sides of the safety rod 130. The rod bracket 115 may be formed in an approximately "U" shape.

Holes, into which a rotary pin 115p is insertable, may be formed in opposite surfaces of the rod bracket 115. In case that the safety rod 130 is accommodated in the rod bracket 115, the rotary pin 115p may simultaneously pass through the rod bracket 115 and the safety rod 130 and may be fixed so that the safety rod 130 is fixed to the inner side of the rod bracket 115.

The fixing clip 116 may be a portion where another end of the safety rod 130 which is not connected to the rod bracket 115 is accommodated when the door 120 is in a closed state. The fixing clip 116 may be disposed on a surface of the main body 110. A plurality of fixing clips 116 may also be disposed on opposite sides of the main body 110 and may fix another end of the safety rod 130 which no longer supports the door 120 when the door 120 is in a closed state.

For example, the end portion of the safety rod 130, which comes into contact with the door 120 in an opened state, may be positioned and fixed on the main body 110 in such a manner that the end of the safety rod 130 is moved down and fitted into the fixing clip 116 when the door 120 is in a closed state.

The door bracket 117 may be disposed on a surface of the main body 110 where the opening 111 is formed, and may be formed in an approximately "⊏" shape. A surface of the door bracket 117 may be disposed on the main body 110, and another surface of the door bracket 117 may come into contact with the door 120 when the door 120 is in a closed state. At this time, in case that the door bracket 117 is fastened to the door 120, the door 120 may be fixed to the main body 110 and maintained in a closed state.

An upper end portion (an upper portion in FIG. 4) of the door 120 may be rotatably connected to the main body 110 through a door hinge 123, and side portions (left and right portions in FIG. 4) of the door 120 connected to the upper portion of the door 120 may be fixed to the main body 110 through the door bracket 117.

In some embodiments, a lower end portion (a lower portion in FIG. 4) of the door 120 may be fastened to the external structure ES through an extension tab 121. Accordingly, all four edges of the door 120 may be fixed to the main body 110 and the external structure ES.

The door 120 may be coupled to the main body 110, may cover the opening 111, and may have a width corresponding to a surface of the main body 110.

In the present specification, a state in which the door 120 is closed (a state in FIG. 4) refers to a state in which the door 120 covers the opening 111, and a state in which the door 120 is opened (a state in FIG. 5) refers to a state in which the door 120 does not cover the opening 111 and is disposed at a preset angle with respect to the main body 110.

The door 120 may include the extension tab 121 connected to the external structure ES. The extension tab 121 is a portion which extends toward the external structure ES when the door 120 is in a closed state, and may come into contact with a surface of the external structure ES.

The extension tab 121 may be a portion fastened to the external structure ES and may have fixing holes 121h spaced apart from each other by preset intervals.

The extension tab 121 may come into contact with a surface of the external structure ES in a state in which the door 120 covers the opening 111, i.e., in a state in which the door 120 is closed. At this time, the positions of the fixing holes 121h may match the positions of the holes formed in the external structure ES. In this state, the door 120 and the external structure ES may be fastened to each other through a fastening element.

A plurality of extension tabs 121 may be provided. In some embodiments, the extension tabs 121 may be respectively disposed on opposite sides of the door 120.

Referring to FIGS. 4 and 5, the plurality of extension tabs 121 may be spaced apart from each other by preset intervals. A recessed portion 122 refers to a gap formed as the plurality of extension tabs 121 are spaced apart from each other, and may be a portion which does not extend from the door 120.

When the door 120 is in a closed state, a lower portion of the fixing member GM may be disposed in the recessed portion 122 which is the gap between the extension tabs 121. In other words, a side of the fixing member GM connected to the external structure ES may be disposed in the recessed portion 122.

The door hinge 123 and a rod support portion 124 may be formed on a surface of the door 120 facing the main body 110.

The door hinge 123 may be formed on a surface of the door 120 facing the hinge bracket 114 of the main body 110. For example, the door hinge 123 may be disposed inside the hinge bracket 114 of the main body 110. A pin may simultaneously pass through the door hinge 123 and the hinge bracket 114 and fix the door hinge 123 to the hinge bracket 114.

Due to this, the door 120 may be rotatable in a hinged manner relative to the main body 110.

A plurality of door hinges 123 may be disposed along the second direction. In case that the plurality of door hinges 123 are disposed, hinge brackets 114 connected to the door hinges 123 may also be disposed in the same number and connected to each other.

A rod support portion 124 may be further formed on a surface of the door 120 facing the main body 110. The rod support portion 124 may protrude along the first direction with respect to the closed state of the door 120, and may support the safety rod 130 when the door 120 is in an opened state.

For example, the rod support portion 124 may protrude in a shape that surrounds an end portion of the safety rod 130 which comes into contact with the door 120. In case that the door 120 is opened, an end portion of the safety rod 130 which is fitted into the fixing clip 116 of the main body 110 may be lifted upward and seated on the rod support portion 124.

At this time, the door 120 may be supported by the safety rod 130, and the door 120 may be prevented from being closed.

In case that the safety rods 130 are disposed on opposite sides of the main body 110, the rod support portions 124 may also be disposed on opposite sides of the door 120. Due to this, the plurality of safety rods 130 may come into contact with the plurality of rod support portions 124, and the door 120 may be stably maintained in an opened state by the safety rods 130.

The safety rod 130 may have an elongated rod shape in which an end thereof is rotatably connected to the main body 110 and another end thereof is supported on the door 120.

The safety rod 130 may be disposed between the main body 110 and the door 120 to support the door 120 so that the door 120 maintains the opened state without being closed.

When the door 120 is in an opened state, an end of the safety rod 130 connected to the main body 110 may be accommodated in the rod bracket 115, and another end of the safety rod 130 connected to the door 120 may come into contact with the rod support portion 124.

The rotary pin 115p of the main body 110 may be inserted into the end of the safety rod 130 connected to the main body 110, and a rod hole 130h having an elongated hole shape may be formed.

In case that the safety rod 130 is disposed inside the rod bracket 115, the rod bracket 115 and the rod hole 130h may be fixed by the rotary pin 115p.

The rod hole 130h may have an elongated hole shape. For example, the rod hole 130h may be formed to have a length along the longitudinal direction of the safety rod 130. Due to such a shape, the safety rod 130 may move flexibly within a certain radius of movement.

Due to the rod hole 130h having an elongated hole shape, the safety rod 130 may move a certain distance along the longitudinal direction of the safety rod 130 even in a state of being fixed to the rod bracket 115. In case that the door 120 is fixed in an opened state, the safety rod 130 may be easily mounted on the rod support portion 124.

In some embodiments, even in case that the door 120 is closed by separating the safety rod 130 from the rod support portion 124, the end of the safety rod 130 fixed to the main body 110 may be moved by the length of the elongated hole, and thus, may be easily mounted on the fixing clip 116.

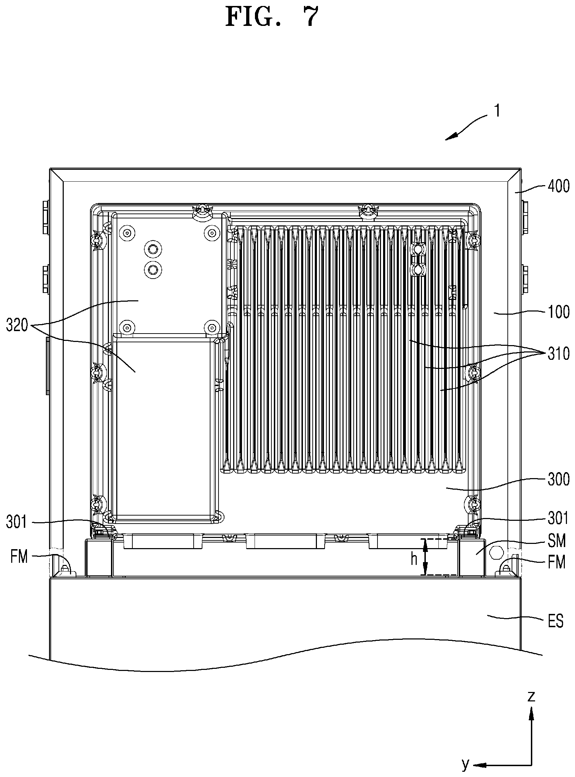

FIG. 7 is a rear view of the inverter 1 for an ESS illustrated in FIG. 2. FIG. 8 is a bottom view of the inverter 1 for an ESS illustrated in FIG. 2.

Referring to FIGS. 7 and 8, the inverter 1 for an ESS may include a heat dissipation case 300 disposed to cover a main case 100 and protruding along the first direction.

The heat dissipation case 300 may further include a support plate 301, a heat dissipation fin 310, and an accommodation portion 320.

The support plate 301 may have a surface facing an external structure ES, may protrude from a lower end portion of the heat dissipation case 300 (in FIG. 7), and may be connected to a support member SM to be described below.

For example, the support plate 301 may be disposed parallel to an upper surface of the external structure ES on which the inverter 1 for an ESS is seated.

A support member SM may be disposed between the support plate 301 and the external structure ES, which are disposed in parallel. An end portion of the support member SM may be connected to the external structure ES, and another end portion of the support member SM may be connected to the support plate 301.

The heat dissipation case 300 may be connected to the support member SM through the support plate 301 and stably fixed on the external structure ES.

The support plates 301 may be symmetrically disposed on opposite sides of the heat dissipation case 300, and the support members SM connected to the support plates 301 may also support opposite sides of the heat dissipation case 300.

In case that the support plates 301 are disposed on the opposite sides of the heat dissipation case 300 so that the opposite sides of the heat dissipation case 300 are respectively supported, the weights of the heat dissipation case 300 and a circuit board 200 accommodated in the heat dissipation case 300 may be distributed to opposite sides, and the risk of deformation or damage due to the weight of the heat dissipation case 300 may be reduced.

Furthermore, resistance to external force and vibration may increase, and thus, balance may be stably maintained.

A plurality of heat dissipation fins 310 may be provided. The plurality of heat dissipation fins 310 may protrude along the first direction and may be disposed on a surface of the heat dissipation case 300.

The plurality of heat dissipation fins 310 may extend along the third direction, may have a long and thin shape, and may be spaced apart from each other by preset intervals on the heat dissipation case 300. Due to the optimized structure of the heat dissipation fins 310, the surface area of the heat dissipation case 300 may be maximized and heat dissipation efficiency may be increased.

The heat dissipation fins 310 may be formed of various materials. For example, the heat dissipation fins 310 may be formed of a metal material with high thermal conductivity, such as aluminum or copper. However, the disclosure is not limited thereto, and the heat dissipation fins 310 may be modified by using various materials within the technical concept of efficiently dissipating heat inside the heat dissipation case 300 due to high thermal conductivity.

The accommodation portion 320 may be disposed on a side of the heat dissipation case 300 and may have an internal space formed therein. A portion of the circuit board 200 may be accommodated in the internal space. The accommodation portion 320 may be disposed adjacent to the heat dissipation fins 310.

Referring to FIGS. 7 and 8, a hood cover 400 may surround the heat dissipation case 300 and may be connected to the main case 100 to protect the heat dissipation case 300 from external impact.

The hood cover 400 may include side covers 410 and a connection cover 420.

The side cover 410 may extend along the side surface of the heat dissipation case 300 and may be provided as a pair on opposite side surfaces of the heat dissipation case 300.

In other words, the side covers 410 may respectively extend from opposite side surfaces of the heat dissipation case 300 along the third direction. Lower end portions (lower portions in FIG. 7) of the pair of side covers 410 may each be fastened to the external structure ES.

At this time, opposite ends of one side cover 410 may also be fastened to the external structure ES. Accordingly, the hood cover 400 may be fastened to the external structure ES at a total of four locations.

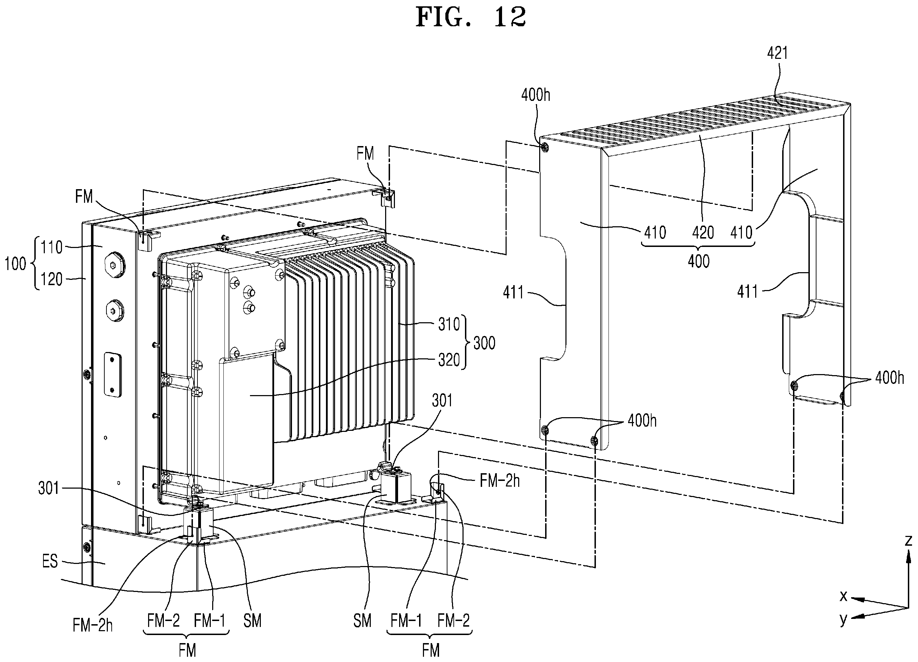

The side cover 410 may have a connection hole (see 400h of FIG. 12) which is a portion through which a fastening element connecting the hood cover 400 to a fastening member FM passes. For example, the number of connection holes (see 400h of FIG. 12) may be equal to the number of fastening members FM connected to the hood cover 400. Accordingly, the connection holes (see 400h of FIG. 12) may be respectively disposed at the lower ends of the pair of side covers 410, and two connection holes (see 400h of FIG. 12) may be disposed at the lower end of one side cover 410 along the first direction.

The connection holes (see 400h of FIG. 12) may also be formed at the upper end of the side cover 410. At this time, the fastening member FM may also be disposed at the upper end of the side cover 410 and fastened to the hood cover 400.

Referring again to FIG. 4, a handle 411 may be formed along a side of the side cover 410. The handle 411 may have a structure in which a surface of the side cover 410 is recessed along the first direction, and may be formed by cutting the surface of the side cover 410.

The handle 411 may be formed in each of the pair of side covers 410. A pair of handles 411 may be formed in a symmetrical structure so that a user may easily hold the hood cover 400 when installing and disassembling the hood cover 400.

A corner portion of the handle 411 may be processed into a round shape. This allows the user to wrap the hood cover 400 stably without any foreign body sensation when holding the hood cover 400.

The hood cover 400 may include the connection cover 420 which connects the pair of side covers 410 to each other. The connection cover 420 may be disposed between the side covers 410 and may extend along the second direction.

The hood cover 400 may have the plurality of cover holes 421 which communicate the interior with the exterior and extend along the first direction.

The plurality of cover holes 421 may be disposed in the connection cover 420 and may be spaced apart from each other by preset intervals on the connection cover 420. For example, the plurality of cover holes 421 may be spaced apart from each other along the second direction, which is the longitudinal direction of the connection cover 420.

The plurality of cover holes 421 may be passages through which heat from the heat dissipation fins 310 escapes. Because both the plurality of heat dissipation fins 310 and the plurality of cover holes 421 are spaced apart from each other along the second direction, heat discharged through the heat dissipation fins 310 may be easily discharged to the outside through the cover holes 421.

Furthermore, the cover holes 421 may connect the interior to the exterior of the hood cover 400 so that air circulation inside and outside the inverter 1 for an ESS is facilitated, and thus, heat may be prevented from accumulating in a specific region.

The hood cover 400 may be formed of a material having an elastic restoring force. In other words, the hood cover 400 may be formed of a flexible material and may be easily positioned and adjusted on the heat dissipation case 300 when installing the inverter 1 for an ESS.

For example, when installing the inverter 1 for an ESS on a wall, the main case 100 is first fixed. Accordingly, in some cases, the hood cover 400 has to be inserted between the main case 100 and the wall. At this time, it may be difficult to accurately align the hood cover 400 to the fastening position on the external structure ES while inserting the hood cover 400 into the gap between the main case 100 and the wall.

In case that the hood cover 400 is flexible, the user may deform the hood cover 400 into a shape which is easy to insert and then insert the hood cover 400 between the main case 100 and the wall. Furthermore, the hood cover 400 may be easily disposed at the fastening position, and thus, installation convenience may be improved.

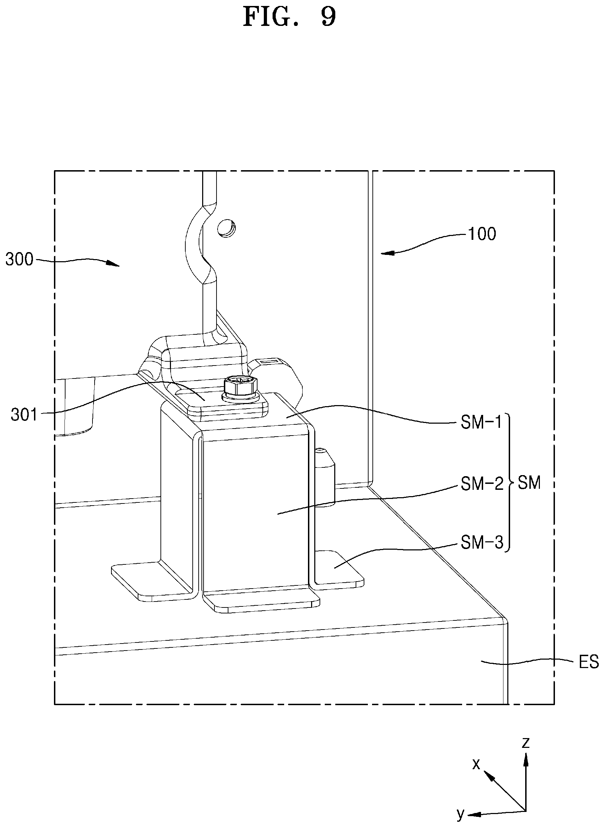

FIG. 9 is a diagram illustrating a state in which the heat dissipation case 300 is seated on the support member SM, according to an embodiment.

Referring to FIGS. 7 to 9, the inverter 1 for an ESS may further include the support member SM between the heat dissipation case 300 and the external structure ES.

For example, the support member SM may have a side connected to the support plate 301 and another side connected to the upper surface of the external structure ES. The support member SM may space the heat dissipation case 300 and the external structure ES apart from each other by preset intervals while supporting the heat dissipation case 300.

The support member SM may be formed in a pillar shape and may include a contact surface portion SM-1, a side surface portion SM-2, and a support surface portion SM-3. The contact surface portion SM-1 may be the upper surface (the top surface in FIG. 7) of the support member SM, that is, a surface that comes into contact with the support plate 301.

In some embodiments, the contact surface portion SM-1 may be a portion where the inverter 1 for an ESS is first seated when installed on the external structure ES. The lower surface of the support plate 301 and the upper surface of the contact surface portion SM-1 may be disposed in contact with each other and then fixed through the fastening element.

The side surface portion SM-2 extending along the third direction may be disposed at each edge of the contact surface portion SM-1. The side surface portion SM-2 may form the side surface of the support member SM and may connect the contact surface portion SM-1 to the support surface portion SM-3.

The support surface portion SM-3 may be disposed at an end of the side surface portion SM-2 which is not connected to the contact surface portion SM-1.

The support surface portion SM-3, which is a portion connected to the external structure ES, may be disposed in a direction facing the outside of the support member SM.

Accordingly, in case that the heat dissipation case 300 is supported by the support member SM, the weights of the heat dissipation case 300 and the circuit board 200 accommodated in the heat dissipation case 300 may be distributed and supported to opposite sides, and thus, the heat dissipation case 300 may be stably positioned on the external structure ES.

Referring to FIG. 7, the support member SM may space the external structure ES and the heat dissipation case 300 by an interval h. At this time, the interval h between the external structure ES and the heat dissipation case 300 may be equal to the height of the support member SM in the third direction.

This may form a separation space between the external structure ES and the heat dissipation case 300. Heat may be released through the separation space and air may be efficiently circulated to prevent overheating of the inverter 1 for an ESS.

Furthermore, the separation space may prevent vibration generated in a device from being transferred to another device, and thus, the stability of the entire device may be improved.

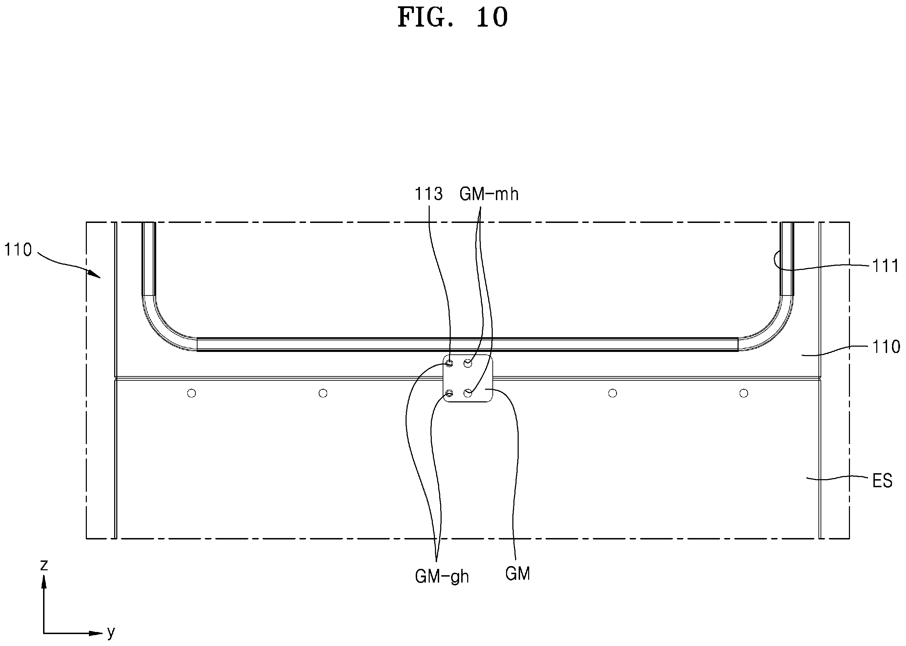

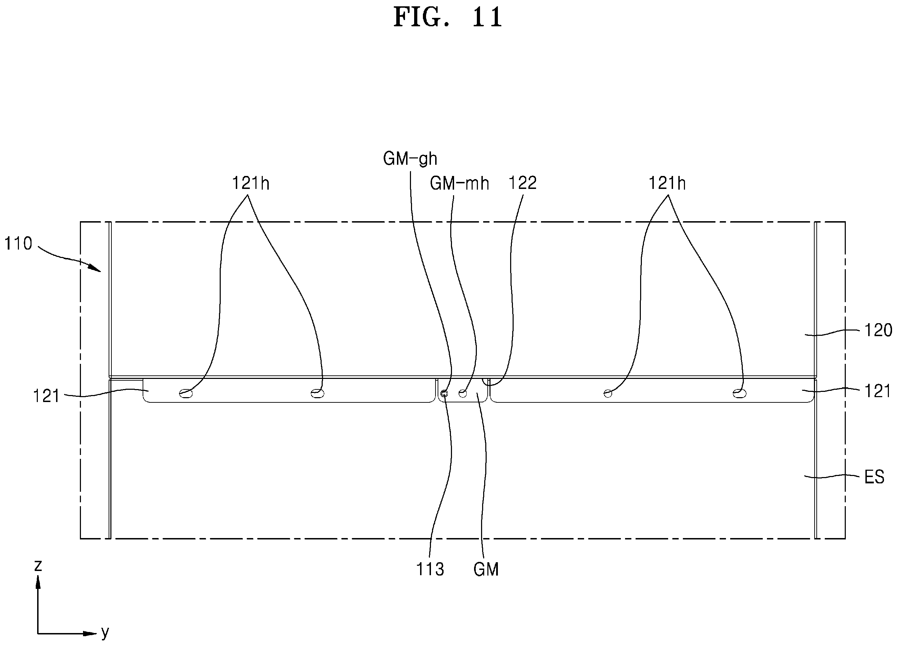

FIG. 10 is a diagram illustrating a state in which the fixing member GM aligns the main case 100 and the external structure ES, according to an embodiment. FIG. 11 is a diagram illustrating a state in which the main case 100 is fastened to the external structure ES, according to an embodiment.

Referring to FIGS. 10 and 11, the fixing member GM may have a side connected to the main case 100 and another side connected to the external structure ES, and may have a guide hole GM-gh therein through which a protrusion may pass.

The fixing member GM may extend along the third direction. A plurality of guide holes GM-gh may be spaced apart from each other along the third direction.

For example, guide protrusions 113 of the main body 110 may be respectively inserted into the guide holes GM-gh formed in a region adjacent to the main case 100. In some embodiments, a plurality of protrusions protruding from a surface of the external structure ES may be respectively inserted into the guide holes GM-gh formed in a region adjacent to the external structure ES.

For example, the guide holes GM-gh formed in the fixing member GM may be respectively connected to the main case 100 and the external structure ES. The plurality of protrusions may be sequentially connected to the guide holes GM-gh, and thus, the inverter 1 for an ESS and the external structure ES may be aligned in a straight line.

The fixing member GM may further include mounting holes GM-mh disposed on sides of the guide holes GM-gh. Similar to the guide holes GM-gh, the mounting holes GM-mh may also be disposed on the fixing member GM along the third direction.

The fastening elements, such as screws, may pass through the mounting holes GM-mh. The fastening elements may pass through the mounting holes GM-mh and fix the fixing member GM to the external structure ES and the main case 100.

For example, the inverter 1 for an ESS and the fixing member GM may be fastened to each other through the mounting holes GM-mh formed in a region adjacent to the main case 100. The external structure ES and the fixing member GM may be fastened to each other through the mounting holes formed in a region adjacent to the external structure ES.

FIG. 12 is a diagram illustrating a state in which the hood cover 400 is coupled to the external structure ES, according to an embodiment.

The fastening member FM may connect the hood cover 400 to the external structure ES and may have a first fastening terminal FM-1 connected to the external structure ES and a second fastening terminal FM-2 connected to the hood cover 400.

The fastening member FM may be formed in an approximately "¬" or " ∟ " shape according to a viewing direction. At this time, a portion connected to the external structure ES may be defined as the first fastening terminal FM-1, and a portion connected to the hood cover 400 may be defined as the second fastening terminal FM-2.

In some embodiments, the first fastening terminal FM-1 and the second fastening terminal FM-2 may be disposed perpendicular to each other.

A first fastening hole FM-1h and a second fastening hole FM-2h may be respectively formed in the first fastening terminal FM-1 and the second fastening terminal FM-2. The first fastening hole FM-1h and the second fastening hole FM-2h may be portions through which the fastening element passes in case that the fastening member FM is connected to the hood cover 400 and the external structure ES.

For example, the first fastening terminal FM-1 may come into contact with the external structure ES and may be fixed to the external structure ES through the fastening element passing through the first fastening hole FM-1h. However, the disclosure is not limited thereto. A protrusion may be formed on a surface of the external structure ES on which the first fastening terminal FM-1 is disposed, and the protrusion may be fixed by passing through the first fastening hole FM-1h.

The second fastening terminal FM-2 may be connected to the first fastening terminal FM-1 and may come into contact with the hood cover 400. The second fastening terminal FM-2 may be fixed to the hood cover 400 through the fastening element passing through the second fastening hole FM-2h.

For example, in case that the hood cover 400 is disposed in the second fastening terminal FM-2, the second fastening hole FM-2h and the connection hole 400h of the hood cover 400 may be disposed to have the same center. At this time, the second fastening hole FM-2h and the connection hole 400h may be fixed to the fastening element.

The hood cover 400 may be fixed to the external structure ES in such a manner that the first fastening terminal FM-1 of the fastening member FM is connected to the external structure ES and the second fastening terminal FM-2 is connected to the hood cover 400. As a total of four fastening members FM are connected to the lower end portion of the hood cover 400, the hood cover 400 may be fixed on the external structure ES along the first direction and the second direction.

Hereinafter, a method of installing an inverter for an ESS, according to an embodiment, is described.

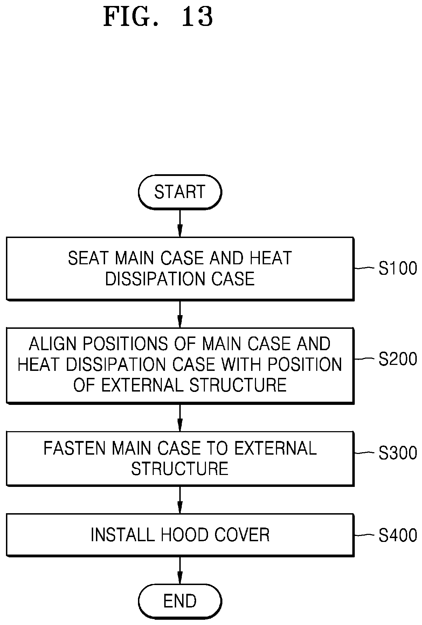

FIG. 13 is a flowchart schematically showing a method of installing an inverter for an ESS, according to an embodiment.

Referring to FIG. 13, the method of installing an inverter for an ESS may include seating, on an external structure, a main case accommodating a circuit board therein and a heat dissipation case disposed on a side of the main case (S100), aligning positions of the main case and the heat dissipation case with a position of the external structure (S200), fastening the main case to the external structure (S300), and installing a hood cover to cover the heat dissipation case (S400).

The seating of, on the external structure, the main case and the heat dissipation case disposed on the side of the main case (S100) may include disposing the main case 100 on the external structure ES and connecting the heat dissipation case 300 to the external structure ES through the support member SM.

For example, the support plate 301 of the heat dissipation case 300 may be seated on the contact surface portion SM-1 of the support member SM. At this time, the support surface portion SM-3 of the support member SM may be in a state of being connected to the external structure ES.

In case that the support plate 301 is seated on the contact surface portion SM-1, and then, the support plate 301 and the support member SM are connected to each other through the fastening element, such as a screw, the heat dissipation case 300 may be fixed on the external structure ES.

The aligning of the positions of the main case and the heat dissipation case with the position of the external structure (S200) may include matching the center of the main case with the center of the external structure and fixing the main case to the external structure in a state in which the center of the main case matches the center of the external structure.

After the fixing of the heat dissipation case 300 is completed, a process of aligning the main case 100 with the external structure ES so that the main case 100 and the external structure ES are easily fastened to each other may be required so as to fix the main case 100 on the external structure ES.

Referring to FIG. 10, the matching of the center of the main case 100 with the center of the external structure ES may be performed by using the fixing member GM when the door 120 is in an opened state.

For example, the guide protrusion 113 of the main body 110 may pass through the guide hole GM-gh formed in a side of the fixing member GM, and the protrusion formed on the external structure ES may pass through the guide hole GM-gh formed in another side of the fixing member GM.

Accordingly, the main case 100 and the external structure ES may be aligned to have the same center along the third direction, and opposite sides of the main case 100 and the external structure ES may be aligned to match each other.

The fixing of the main case 100 to the external structure in a state in which the center of the main case 100 matches the center of the external structure ES may include fixing the fixing member GM to the main case 100 and the external structure ES.

For example, in case that the main case 100 is aligned with the external structure ES, and then, the fastening element is inserted into the mounting hole GM-mh of the fixing member GM, the main case 100 and the external structure ES may be fixed to each other in an aligned state.

As described above, in case that the external structure ES and the inverter 1 for an ESS are pre-aligned with each other by the fixing member GM before the inverter 1 for an ESS is actually fixed to the external structure ES, the installation process may be simplified and the time and effort may be saved.

The fastening of the main case 100 to the external structure ES (S300) may be performed when the door 120 is in a closed state.

Referring to FIG. 11, when the door 120 is in a closed state, the extension tab 121 may come into contact with a surface of the external structure ES. At this time, the fixing member GM may be disposed in the recessed portion 122 between the extension tabs 121.

In case that the door 120 is closed in a state in which the main case 100 and the external structure ES are aligned with each other by the fixing member GM, the fixing hole 121h formed in the extension tab 121 and the fastening hole formed in the external structure ES may accurately match each other. At this time, the fastening element may simultaneously pass through the fixing hole 121h and the fastening hole formed in the external structure ES and may fasten the door 120 to the external structure ES.

Accordingly, while the main case 100 is in a closed state, the door 120 and the external structure ES may be fastened to each other along the second direction.

The installing of the hood cover 400 to surround the heat dissipation case 300 (S400) may include disposing the hood cover 400 to surround three surfaces of the heat dissipation case 300 and fixing the hood cover 400 on the external structure ES.

The installing of the hood cover 400 to surround the heat dissipation case 300 (S400) may include disposing the hood cover 400 to surround the heat dissipation case 300, and fixing the hood cover 400 to the external structure ES by fastening the first fastening terminal FM-1 of the fastening member FM to the external structure ES and fastening the second fastening terminal FM-2 of the fastening member FM to the hood cover 400.

The disposing of the hood cover 400 to surround the heat dissipation case 300 may include disposing the hood cover 400 so that the pair of side covers 410 cover the side of the heat dissipation case 300 and the connection cover 420 covers the upper surface of the heat dissipation case 300.

In some embodiments, the disposing of the hood cover 400 to surround the heat dissipation case 300 may include disposing the hood cover 400 so that each end portion of the hood cover 400 fastened to the external structure ES is disposed in the second fastening terminal FM-2 of the fastening member FM.

The hood cover 400 may be formed of a flexible material having an elastic restoring force. Accordingly, in case that the inverter 1 for an ESS is installed on the wall, the hood cover 400 may be easily inserted into the gap between the main case 100 and the wall.

The installation of the inverter 1 for an ESS may be completed by fixing the first fastening terminal FM-1 of the fastening member FM to the external structure ES and fixing the hood cover 400 to the second fastening terminal FM-2.

Because the inverter 1 for an ESS, according to an embodiment, is configured to be separated from the external structure ES, only the components to be replaced may be easily separated and then replaced in a situation where replacement of parts is required. Therefore, the convenience of replacement may be improved and the costs required for product maintenance may be saved.

Furthermore, according to the disclosure, the inverter 1 for an ESS may be firmly fixed by fixing the inverter 1 for an ESS on the external structure ES in three axes, and easy installation and maintenance may be achieved in various environments.

While the embodiments have been described above, the concept of the disclosure is not limited to the embodiments presented in the present specification. It will be understood by those of ordinary skill in the art that various modifications and changes may be made thereto through inclusion, change, removal, or addition of components without departing from the spirit and scope of the disclosure. Furthermore, it will be understood that this also falls within the scope of the disclosure.

## Claims

1. An inverter for an energy storage system, the inverter comprising:
a main case having an internal space and installed in an external structure;
a circuit board disposed in the internal space and configured to interconvert direct current (DC) power and alternating current (AC) power into each other;
a heat dissipation case disposed to cover the main case and protruding along a first direction; and
a hood cover surrounding the heat dissipation case and connected to the main case.

2. The inverter of claim 1, wherein the main case comprises:
a main body having the internal space in which the circuit board is accommodated and having an opening on another side of the main body; and
a door coupled to the main body and capable of covering the opening.

3. The inverter of claim 2, wherein the main body has a guide protrusion protruding from a surface of the main body.

4. The inverter of claim 2 or 3, wherein the door comprises an extension tab connected to the external structure and having fixing holes spaced apart from each other by preset intervals.

5. The inverter of any one of claims 2 to 4, wherein the main case further comprises a safety rod having an end rotatably connected to the main body and another end supported on the door.

6. The inverter of claim 5, wherein the safety rod has a rod hole having an elongated hole shape into which a rotary pin of the main body is inserted.

7. The inverter of any one of the preceding claims, wherein the heat dissipation case comprises a heat dissipation fin protruding along the first direction.

8. The inverter of any one of the preceding claims, wherein the hood cover comprises:
a pair of side covers extending along a side surface of the heat dissipation case; and
a connection cover connecting the pair of side covers to each other.

9. The inverter of any one of the preceding claims, wherein the hood cover has a plurality of cover holes communicating an interior with an exterior and extending along the first direction.

10. The inverter of any one of the preceding claims, further comprising a fastening member having a first fastening terminal connected to the external structure and a second fastening terminal connected to the hood cover.

11. The inverter of any one of the preceding claims, further comprising a support member disposed between the heat dissipation case and the external structure and supporting the heat dissipation case.

12. A method of installing an inverter for an energy storage system, the method comprising:
seating, on an external structure, a main case accommodating a circuit board therein and a heat dissipation case disposed on a side of the main case;
aligning positions of the main case and the heat dissipation case with a position of the external structure;
fastening the main case to the external structure; and
installing a hood cover to cover the heat dissipation case.

13. The method of claim 12, wherein the aligning comprises:
matching a center of the main case with a center of the external structure; and
fixing the main case to the external structure in a state in which the center of the main case matches the center of the external structure.

14. The method of claim 12 or 13, wherein the installing of the hood cover comprises:
disposing the hood cover to surround the heat dissipation case; and
fixing the hood cover to the external structure by fastening a first fastening terminal of a fastening member to the external structure and fastening a second fastening terminal of the fastening member to the hood cover.
